# EUROPÄISCHE PATENTSCHRIFT

(11) **EP 1 227 999 B1**
(45) Veröffentlichungstag und Bekanntmachung des Hinweises auf die Patenterteilung: **02.05.2003**
(21) Anmeldenummer: 00952786.2
(22) Anmeldetag: 03.08.2000
(51) Int. Cl.: C01B 31/02, H01J 9/02, C23C 16/46, C23C 16/26

(54) **VERFAHREN ZUR HERSTELLUNG EINER NANOTUBE-SCHICHT AUF EINEM SUBSTRAT**
METHOD FOR PRODUCING A NANOTUBE LAYER ON A SUBSTRATE
PROCEDE POUR LA PRODUCTION D'UNE COUCHE DE NANOTUBES SUR UN SUBSTRAT

(30) Priorität: 29.09.1999 AT 166799
(43) Veröffentlichungstag der Anmeldung: 07.08.2002
(73) Patentinhaber: ELECTROVAC FABRIKATION ELEKTROTECHNISCHER SPEZIALARTIKEL GESELLSCHAFT M.B.H., 3400 Klosterneuburg (AT)
(72) Erfinder: MAUTHNER, Klaus, A-1040 Wien (AT); TANG, Xinhe, 1220 Wien (AT); HAUBNER, Roland, 1040 Wien (AT)
(74) Vertreter: Gibler, Ferdinand, Dipl.-Ing. Dr. techn.
(86) Internationale Anmeldenummer: AT0000213
(87) Internationale Veröffentlichungsnummer: WO01023303

(56) Entgegenhaltungen:
- US-A- 3 892 890
- PATENT ABSTRACTS OF JAPAN vol. 1998, no. 05, 30. April 1998 (1998-04-30) & JP 10 012364 A (MITSUBISHI ELECTRIC CORP), 16. Januar 1998 (1998-01-16)
- DATABASE WPI Section Ch, Week 199927 Derwent Publications Ltd., London, GB; Class E36, AN 1999-323246 XP002154696 & JP 11 116218 A (OSAKA GAS CO LTD), 27. April 1999 (1999-04-27)
- LEE C J ET AL: "SYNTHESIS OF UNIFORMLY DISTRIBUTED CARBON NANOTUBES ON A LARGE AREAOF SI SUBSTRATES BY THERMAL CHEMICAL VAPOR DEPOSITION" APPLIED PHYSICS LETTERS,US,AMERICAN INSTITUTE OF PHYSICS. NEW YORK, Bd. 75, Nr. 12, 20. September 1999 (1999-09-20), Seiten 1721-1723, XP000868314 ISSN: 0003-6951
- HUANG S ET AL: "PATTERNED GROWTH AND CONTACT TRANSFER OF WELL-ALIGNED CARBON NANOTUBE FILMS" JOURNAL OF PHYSICAL CHEMISTRY. B, MATERIALS, SURFACES, INTERFACES AND BIOPHYSICAL,WASHINGTON, DC,US, Bd. 103, Nr. 21, 27. Mai 1999 (1999-05-27), Seiten 4223-4227, XP000957804 ISSN: 1089-5647
- CHENG H M ET AL: "LARGE-SCALE AND LOW-COST SYNTHESIS OF SINGLE-WALLED CARBON NANOTUBES BY THE CATALYTIC PYROLYSIS OF HYDROCARBONS" APPLIED PHYSICS LETTERS,US,AMERICAN INSTITUTE OF PHYSICS. NEW YORK, Bd. 72, Nr. 25, 22. Juni 1998 (1998-06-22), Seiten 3282-3284, XP000771129 ISSN: 0003-6951
- SEN R ET AL: "CARBON NANOTUBES BY THE METALLOCENE ROUTE" CHEMICAL PHYSICS LETTERS,AMSTERDAM,NL, Bd. 267, Nr. 3/04, März 1997 (1997-03), Seiten 276-280, XP000878963
- SATISHKUMAR B C ET AL: "SINGLE-WALLED NANOTUBES BY THE PYROLYSIS OF ACETYLENE- ORGANOMETALLIC MIXTURES" CHEMICAL PHYSICS LETTERS,AMSTERDAM,NL, Bd. 293, Nr. 1/02, August 1998 (1998-08), Seiten 47-52, XP000878960

## Beschreibung

Die Erfindung bezieht sich auf ein Verfahren zur Herstellung einer Nanotube-Schicht auf einem Substrat durch einen katalytischen CVD-Prozeß, bei welchem das Substrat in eine Reaktionskammer eingebracht wird, diese Reaktionskammer mit einem kohlenstoffhältigen Gas gespült wird und das Substrat auf eine Temperatur aufgeheizt wird, bei welcher Kohlenstoff aus der Gasphase am Substrat abgeschieden wird und dort Nanotubes bildet.

Carbon Nanotubes sind bienenwabenförmig aufgebaute, zylindrische Röhren aus sp²-Kohlenstoff. Je nach Herstellungsbedingungen unterscheidet man SWNT (Single Wall Nanotubes) oder MWNT (Multiwalled Nanotubes). Die freistehenden Enden der Nanoröhren sind unter den gebräuchlichen Synthesebedingungen durch Halbkugeln, welche durch den Einbau von genau sechs pentagonalen. Einheiten in die hexagonale Graphit-Struktur entstehen, verschlossen. Das wissenschaftliche und in der Folge industrielle Interesse an solchen Nanostrukturen beruht auf ihren hervorragenden mechanischen und elektronischen Eigenschaften. Die Grössenordnung derartiger Strukturen bewegen sich im nm-(Durchmesser)/ µm-Bereich (Länge), welche besonders auf dem Gebiet der Mikroelektronik technologische Anwendungen versprechen. Mit Blick auf die einschlägige Fachliteratur ist es unschwer zu erkennen, dass heftigste Aktivitäten, Carbon Nanotubes der FED-Technologie zuzuführen, im Gange sind.

Obwohl schon viel über die Herstellung von Carbon Nanotubes in der Literatur berichtet wurde, scheint der Durchbruch, bezüglich industrieller Verwertbarkeit von Nanotube-Schichten in der Emissionstechnologie, noch immer ein heisses allerding erst zu schmiedendes Eisen zu sein. Die Darstellungsvarianten für Nanotubes reichen von Lichtbogenentladungsprozessen, welche bei Temperaturen um 3000°C stattfinden, über Zersetzungsreaktionen von SiC-Wafern bei 1200°C unter Hochvakuum, bis zu CVD-Methoden welche, lant Literatur, Generierungstemperaturen für Nanotubes bis zu einer Temperaturuntergrenze von 650°C erlauben. Ein auf alle bekannten Herstellungsprozesse zutreffender Punkt ist der Begriff der katalysierten σ-Bond Metathese, welche schlicht besagt, dass der Bildungsmechanismus von Carbon Nanotubes noch ausschliesslich Gegenstand spekulativer Überlegungen ist. Zahlreiche Experimente bestätigen Übergangsmetallen, aber auch einigen Elementen aus der Lanthanidengruppe katalytische Aktivität in der Fulleren/Nanotube Synthese, wobei angenommen werden darf, dass der ideale Katalysator/die ideale Katalysatorkomposition möglicherweise noch nicht zur Anwendung gekommen ist.

Ein wichtiger Punkt, ein Material technischen Anwendungen zugänglich zu machen, ist die vernünftig automatisierbare Verfahrenstechnik, welche, speziell im Falle der Mikroelektronik, hohen Reinraum-Prozesstechnik-Anforderungen genüge tun muss.

Nanotube-Schichten werden in der Regel durch Abscheidung von Kohlenstoff-Atomen aus einem kohlenstoffhaltigen Trägergas auf die Oberfläche eines Substrates hergestellt. Damit diese Abscheidung stattfinden kann, müssen Reaktionstemperaturen im Bereich zwischen 400 und 2000°C angewendet werden, wobei der konkret zu wählende Temperaturwert vom Substratmaterial sowie von der eingesetzten Kohlenstoffquelle abhängt.

Nach bisher bekanntem Stand der Technik hat man zwecks dieser Aufheizung des Substrates den gesamten Innenraum der Reaktionskammer ähnlich einem Backofen aufgeheizt.

Nachteilig ist bei dieser Vorgangsweise insbesondere, daß dabei nicht nur das Substrat selbst sondern auch sämtliche andere, sich im Inneren der Reaktionskammer befindende Objekte, insbesondere die Innenwandungen der Reaktionskammer, aufgeheizt und damit einer Kohlenstoffabscheidung zugänglich gemacht werden. Es kommt daher zur Bildung von unerwünschten, die Reaktionskammer verschmutzenden Kohlenstoffablagerungen.

Darüberhinaus ist natürlich jene Energie, die zur Aufheizung der vom Substrat verschiedenen Objekte verwendet wird, Verlustenergie, welche die Effizienz des Verfahrens herabsetzt.

Es ist Aufgabe der vorliegenden Erfindung, ein Verfahren der eingangs angeführten Art zur Herstellung einer Nanotube-Struktur auf einem Substrat anzugeben, bei welchem diese Probleme vermieden sind, bei welchem also insbesondere die Bildung unerwünschter Kohlenstoffschichten auf vom Substrat verschiedenen Objekten weitgehend vermieden ist und welches mit deutlich geringeren Wärmeverlusten arbeitet.

Erfindungsgemäß wird dies dadurch erreicht, daß das Substrat induktiv aufgeheizt wird.

Damit wird ausschließlich das Substrat auf jene Temperatur gebracht, welche Voraussetzung für die Abscheidung von Kohlenstoffatomen ist. Sämtliche anderen Bereiche der Reaktionskammer bleiben auf Raumtemperatur bzw. werden von der vom Substrat ausgehenden Wärmestrahlung nur sehr geringfügig erwärmt, welche Erwärmung jedenfalls nicht ausreicht, um eine Kohlenstoff-Abscheidung auf diesen anderen Bereichen der Reaktionskammer zu ermöglichen.

Zum ersten mal wird ein CVD-Verfahren im Zusammenhang mit großflächiger Nanotubefilmabscheidung beschrieben, wobei es nur und d. h. ausschließlich an den gewuenschten und definierten Oberflächen im Reaktor zu Pyrolysereaktionen und damit zu Kohlenstoffabscheidungen kommt. Das Verfahren gewährleistet die Ausbildung von dichten, homogenen Carbon-Nanotube-Schichten unter milden Abscheidungsbedingungen (Druck, Temperatur), und, darauf sei hier speziell hingewiesen, dadurch dass an keinen unbeabsichtigten Oberflaechen im Reaktor feste Ablagerungen durch Pyrolyse gasförmiger kohlenstoffhaeltiger Reaktanten gebildet werden, eine weiterführende Automatisierung zur Produktion von zusammengesetzten Bauteilen für Anwendungen in der Mikroelektronik z.B. FED-Technologie.

Gemäß einer besonders bevorzugten Weiterbildung der Erfindung kann vorgesehen sein, daß das Substrat auf eine innerhalb der Reaktionskammer angeordnete Substrat-Aufnahme gelegt wird, welche durch eine Platte aus elektrisch leitendem Material, wie z.B. Metall oder Graphit, gebildet ist, und das Aufheizen des Substrates durch induktives Beheizen dieser Metallplatte, gegebenenfalls zusätzlich durch induktives Beheizen von metallischen Abschnitten des Substrates erfolgt.

Nichtmetallische Substrate können nicht direkt induktiv aufgeheizt werden, weil sich in ihnen die dafür notwendigen Wirbelströme nicht ausbilden können. Eine Metallplatte hingegen kann induktiv beheizt werden, sodaß durch das Vorsehen einer solchen Metallplatte in der Reaktionskammer und das Plazieren eines nichtmetallischen Substrates auf derselben das erfindungsgemäße induktive Beheizen auch bei nichtmetallischen Substraten -wenngleich nur indirekt durch Übertragung der Wärme von der Metallplatte auf das Substrat- erfolgen kann. Die Metallplatte kann eine relativ geringe Masse aufweisend ausgebildet werden, womit zu ihrer Erwärmung nur geringe Energiemengen notwendig sind. Da andere Komponenten der Reaktionskammer nahezu überhaupt nicht aufgeheizt werden, entfällt die im Stand der Technik dafür verwendete Energie vollständig.

Gemäß einer Variante der Erfindung kann vorgesehen sein, daß ein Substrat, dessen mit der Nanotube-Schicht zu versehende Oberfläche eine Metallbeschichtung aufweist, verwendet wird.

Damit die Abscheidung von Kohlenstoffatomen auf der Substratoberfläche (und damit die Nanotube-Bildung) stattfinden kann, muß auf der Substratoberfläche ein metallischer Katalysator vorhanden sein. Trägt das Substrat eine Metallbeschichtung, so ist dieser Katalysator bereits auf der Substratoberfläche vorhanden und braucht nicht durch einen separaten Verfahrensschritt auf das Substrat aufgebracht werden. Darüberhinaus wird diese Metallbeschichtung direkt induktiv beheizt.

In diesem Zusammenhang kann vorgesehen sein, ein zur Gänze aus einem Metall oder einer Metallegierung bestehendes Substrat verwendet wird.

Auch hier ist der für die Bildung einer Nanotube-Schicht notwendige metallische Katalysator bereits auf der Substratoberfläche vorhanden. Weiters können solche metallische Substrate direkt induktiv beheizt werden, denn es können innerhalb der Substrate selbst die zur induktiven Beheizung notwendigen Wirbelströme erzeugt werden. Man kann daher bei Verwendung metallischer Substrate die bisher erwähnte Metallplatte zur Aufnahme dieser Substrate durch eine nichtmetallische Vorrichtung ersetzten.

Gemäß einer anderen Variante der Erfindung kann vorgesehen sein, daß ein aus einem nichtmetallischen Material, wie z.B. Glas, Keramik, Silizium, Cermet, Kohlenstoff od. dgl. bestehendes Substrat verwendet wird und daß vor dem Spülen der Reaktionskammer mit einem kohlenstoffhältigen Gas ein metallhältiger Katalysator auf die mit der Nanotube-Schicht zu versehende Oberfläche des Substrates aufgebracht wird.

Dies ermöglicht es, Nanotube-Schichten auch auf nichtmetallischen Substraten aufwachsen zu lassen.

Als besonders günstig hat es sich erwiesen, daß als Katalysator ein Übergangsorganometallkomplex, wie z.B. Ferrocen, verwendet wird.

Derartige Substanzen lassen sich mit besonders einfachen Maßnahmen auf die Oberfläche von nichtmetallischen Substraten aufbringen und katalysieren das Wachstum von Kohlenstoff-Nanotubes besonders zuverlässig.

In diesem Zusammenhang kann nach einer bevorzugten Ausführungsform der Erfindung vorgesehen sein, daß Ferrocen in einer Aceton-Lösung aufgelöst wird und diese Aceton-Lösung auf die mit der Nanotube-Schicht zu versehende Oberfläche des Substrates aufgebracht wird.

Nach Verdampfung des Lösungsmittels liegt der Katalysator gleichmäßig verteilt als mikrokristalline Schicht auf dem Substrat vor.

In weiterer Ausgestaltung der Erfindung kann vorgesehen sein, daß als kohlenstoffhältiges Gas Acetylen verwendet wird.

Dieses Gas bewirkt insbesondere in Verbindung mit Ferrocen als Katalysator einen relativ rasch ablaufenden, gute Ergebnisse, d.h. eine sehr homogene Nanotube-Schicht liefernden, Abscheidungsprozeß.

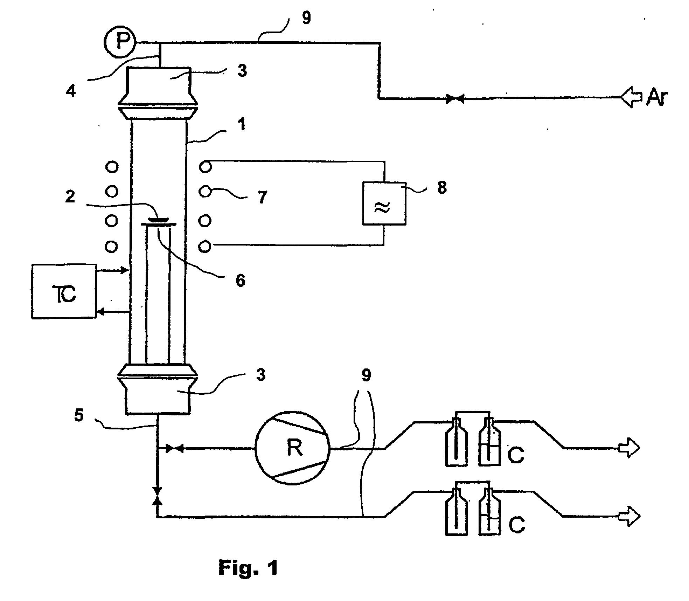

Die Erfindung wird nachstehend unter Bezugnahme auf die einzige Zeichnung Fig. 1 beschrieben. Diese Fig.1 zeigt eine bevorzugte Ausführungsform einer erfindungsgemäßen Vorrichtung zur Herstellung einer Nanotube-Schicht auf einem Substrat in schematischer Darstellung.

Hier ist mit 1 eine Reaktionskammer bezeichnet, innerhalb welcher das erfindungsgemäße Verfahren zur Herstellung einer Nanotube-Schicht auf einem Substrat 2 durchgeführt wird. Dieses Verfahren ist ein seinem Prinzip nach im Stand der Technik bekannter CVD-Prozeß, bei welchem das Substrat 2 in die Reaktionskammer 1 eingebracht wird, danach die Reaktionskammer 1 mit einem kohlenstoffhältigem Gas gespült wird und das Substrat 2 auf eine solche Temperatur aufgeheizt wird, bei welcher Kohlenstoff aus der Gasphase am Substrat 2 abgeschieden wird und dort Nanotubes bildet.

Die konkret zu verwendende Temperatur hängt vom Material des Substrates 2 sowie vom Typ des kohlenstoffhältigen Gases ab. Die Auswahl dieses kohlenstoffhältigen Gases sowie die Temperaturauswahl sind aber nicht erfindungswesentlich sondern können gemäß den hierfür im Stand der Technik bekannten Regeln von jedem Fachmann am Gebiet der CVD-Techniologie durchgeführt werden. Das erfindungsgemäße Verfahren erlaubt den Einsatz von allen Kohlenstoff-hältigen Gasen und organischen Verbindungen (diverse Lösungsmittel mit hohem Kohlenstoff-Anteil) welche sich unterhalb der notwendigen Pyrolysetemperatur im gasförmigen Zustand halten lassen. Abhängig vom gewählten kohlenstoffhältigen Gas können Abscheidetemperaturen im Bereich zwischen 400 und 2000°C notwendig sein.

Die in Fig.1 dargestellte Reaktionskammer 1 ist durch ein vertikal verlaufendes Quarzrohr gebildet, dessen Stirnseiten mit Metallflanschen 3 gasdicht verschlossen sind. In diese Metallflansche 3 sind ein Gaseinlaß 4 und ein Gasauslaß 5 eingearbeitet, über welche der Reaktionskammer 1 Gase zu- und abgeführt werden können. Innerhalb der Reaktionskammer 1 ist eine Substrat-Aufnahme 6 in Gestalt einer ebenen Platte angeordnet, auf welche das Substrat 2 aufgelegt wird. Mit P ist eine Druckregelungs-Einrichtung bezeichnet, mit Hilfe welcher der Gasdruck innerhalb der Reaktionskammer 1 geregelt wird. Das Bezugszeichen R kennzeichnet eine Pumpe, mittels welcher ein Gasstrom durch die Reaktionskarnmer 1 erzeugt werden kann, sollten unter Normalbedingungen winiger flüchtige Substanzen als Kohlenstoffquelle zum Einsatz kommen. Innerhalb der Gasleitungen 8 sind weiters Gasreinigungs-Vorrichtungen C angeordnet.

Der wesentlichste Teil der erfindungsgemäßen Vorrichtung ist die Spule 7, deren Windungen außerhalb der Reaktionskammer 1 liegen und die Reaktionskammer 1 im Bereich der Substrat-Aufnahme 6 umschließen. Diese Spule 7 ist mit einer Wechselspannungsquelle 8 verbindbar, wodurch sie im Bereich der Substrat-Aufnahme 6 und des Substrates 2 ein diese beiden Teile durchsetzendes Wechsel-Magnetfeld aufbaut.

Der Aufbau dieses Wechsel-Magnetfeldes ist Voraussetzung für die erfindungsgemäße Weise der Beheizung des Substrates, diese erfolgt erfindungsgemäß nämlich induktiv. Das bedeutet, daß durch das Wechsel-Magnetfeld im Substrat 2 selbst, in der Substrat-Aufnahme 6 oder in beiden dieser Teile Wirbelspannungen induziert werden, die zur Ausbildung von Wirbelströmen innerhalb von Substrat 2, Substrat-Aufnahme 6 oder beiden Teilen führen. Diese Wirbelströme erzeugen Wärme im Substrat 2, in der Substrat-Aufnahme 6 oder beiden Teilen, womit das Substrat 2 auf die zur Nanotube-Abscheidung notwendige Temperatur geheizt wird.

Der Effekt der induktiven Beheizung ist umso höher, je höher die Frequenz des Wechsel-Magnetfeldes ist, denn bekanntlich verhält sich die Höhe einer induzierten Spannung (und damit auch die Höhe des von dieser Spannung getriebenen (Beheizungs-) Stromes) direkt proportional zur Frequenz des Wechsel-Magnetfeldes. Die Wechselspannungsquelle 8 ist daher vorzugsweise eine Hochfrequenz-Spannungsquelle, welche Frequenzen von größer 1kHz erzeugt.

Ob nur im Substrat 2, nur in der Substrat-Aufnahme 6 oder in beiden Teilen Wirbelströme induziert werden können, hängt von den elektrischen Eigenschaften dieser Bauteile ab. Nanotubes können sowohl auf metallischen als auch auf nichtmetallischen Substraten abgeschieden werden, sodaß das Substrat 2 sowohl leitend als auch nichtleitend sein kann. Wird ein metallisches Substrat 2 oder ein an sich zwar nichtmetallisches aber mit einer Metallbeschichtung versehenes Substrat 2 verwendet, können in diesem Substrat 2 selbst bzw. in seiner Metallbeschichtung Wirbelströme erzeugt werden und damit das Substrat 2 direkt induktiv beheizt werden. Das Material der Substrat-Aufnahme 6 kann dann beliebig gewählt werden, insbesondere kann dieses auch aus einem Nichtmetall, wie z.B. einer Keramik, gebildet sein. Als Materialien zur Bildung von metallischen Substraten, worunter sowohl Substrate aus reinen Metallen als auch Substrate aus Metallegierungen zu verstehen sind, können angegeben werden: Fe, Co, Ni. Cr, Mo, Cu, Ru, Rh, Pd, Pt.

Ein nichtmetallisches Substrat 2, wie z.B. Glas, Keramik, Silizium, Cermet, Kohlenstoff od. dgl., kann hingegen nur indirekt induktiv beheizt werden, indem die Substrat-Aufnahme 6 durch eine Platte aus einem elektrisch leitenden Material, wie z.B. Metall oder Graphit, wird und das Substrat 2 auf diese elektrisch leitende Platte aufgelegt wird. Das von der Spule 7 aufgebaute Wechsel-Magnetfeld ruft dabei Wirbelströme nur innerhalb dieser Platte hervor, die dabei entstehende Wärme muß auf das Substrat 2 übertragen werden.

Bei Verwendung von metallischen Substraten 2 bzw. von metallbeschichteten Nichtmetall-Substraten 2 kann natürlich ebenfalls eine metallische Substrat-Aufnahme 6 verwendet werden, hier werden dann sowohl die Substrat-Aufnahme 6 als auch die metallischen Abschnitte des Substrates 2 direkt induktiv beheizt.

Zur Einstellung der für das aktuell verwendete Substrat 2 und das aktuell verwendete kohlenstoffhältige Gas notwendigen Temperatur ist eine in Fig. 1 mit TC bezeichnete Temperaturregelung vorgesehen, welche die aktuelle Substrattemperatur mißt und abhängig von dieser die Wechselspannungsquelle 8 ansteuert. Diese Ansteuerung kann z.B. im bloßen Ein- und Ausschalten dieser Spannungsquelle 8 liegen (Zweipunkt-Regel-Charakteristik) oder in der stetigen Veränderung von Parametern (Spannung und/oder Frequenz) der Spannungsquelle 8.

Ausgehend von der Tatsache, daß eine Abscheidung von Kohlenstoff aus dem kohlenstoffhältigen Gas auf die Substratoberfläche nur dann stattfinden kann, wenn sich auf der Substratoberfläche in geeigneter metallhältiger Katalysator befindet, ist bei Durchführung des erfindungsgemäßen Verfahrens unter Verwendung eines nichtmetallischen Substrates 2 vorgesehen, vor dem Spülen der Reaktionskammer 1 mit einem kohlenstoffhältigen Gas einen solchen metallhältigen Katalysator auf die mit der Nanotube-Schicht zu versehende Oberfläche des Substrates aufzubringen. Solche metallhältigen Katalysatoren können beispielsweise Metallocene und Übergangsorganometallkomplexe, wie z.B. Ferrocen, sein.

Eine mögliche Form der Katalysatoraufbringung stellt das Imprägnieren von Substraten mit porösen Oberflächen durch Einlegen selbiger in konzentrierte Metallkomplexlösungen dar. Die Imprägnierungsbedingungen (Lösungsmittel, Temperatur, Konzentration) richten sich nach den chemischen Eigenschaften des jeweiligen Metallkomplexes. Poröse Oberflaechen können durch einfache Ätztechniken (z.B. Einwirken von Säuren, anodische Oxidation der Substrate) erhalten werden.

Erfindungswesentlich ist -wie bereits erörtert- nicht der genaue Gesamt-Ablauf des CVD-Prozesses, sondern nur die Art und Weise der Beheizung des Substrates. Deshalb ist die Art und Weise der Vorbehandlung des Substrates 2, der vorbereitenden Spülungen der Reaktionskammer 1 mit Reinigungsgasen, die abschließende Abkühlung des Substrates 2 und dgl. beliebig gemäß den diesbezüglichen für sich bekannten Methoden wählbar.

Ohne diese Erfindung in irgendeiner Weise einzuschränken wird abschließend der gesamte Ablauf einer tatsächlich durchgeführten Vorgangsweise zur Erzeugung einer Nanotube-Schicht auf einem Glassubstrat beschrieben, welcher Ablauf die erfindungsgemäße induktive Beheizung des Substrates 2 beinhaltete: Die Reaktionskammer 1 wurde hier durch ein Quarzrohr mit 80cm Länge und 8cm Durchmesser gebildet, dessen beide Stirnseiten mittels Metallkappen 3, die mit einem Gaseinlaß 4 bzw. einem Gasauslaß 5 versehen sind, verschlossen wurden. Das Substrat 2, auf welchem die Nanotube-Schicht abgeschieden wurde, war eine Platte aus PYREX®-Glas (=ein Borosilicat-Glas) mit einer Größe von 4cm x 2cm x 0.125cm. Diese Platte wurde mit Korund-Pulver aufgerauht, womit eine bessere Verteilung des als Katalysator verwendeten Ferrocen auf der Glasplatte erreichbar ist.

Ferrocen wurde in Aceton aufgelöst und ein paar Tropfen dieser gesättigten Aceton-Lösung wurden auf die Substrat-Oberfläche aufgebracht. Das Aceton verdampfte langsam, was zur Bildung einer mikrokristallinen Ferrocen-Schicht auf der Substratoberfläche führte.

Anschließend wurde das auf diese Weise vorbehandelte PYREX®-Substrat 2 auf die im Inneren der Reaktionskammer 1 befindliche und aus Molybdän bestehende Substrat-Aufnahme 6 gelegt und die Reaktionskammer 1 15min lang mit Stickstoff gespült. Danach wurde Acetylen als kohlenstoffhältiges Trägergas in die Reaktionskammer 1 eingebracht, was ebenfalls durch Spülung der Reaktionskammer 1 mit diesem Trägergas durchgeführt wurde. Der Acetylen-Gasstrom wies dabei eine Strömungsgeschwindigkeit von etwa 15 sccm min⁻¹ auf. Jetzt wurde das Substrat 2 so schnell als möglich auf 650°C aufgeheizt, was entsprechend der Erfindung auf induktivem Weg durch Beaufschlagung der Spule 7 mit einer Wechselspannung von 2 kV bei einem Strom von 0.65mA durchgeführt wurde.

Nach wenigen Sekunden bildete sich Ferrocen-Dampf über dem Substrat aufgrund teilweiser Sublimation dieses Katalysators. Der Ferrocen-Dampf wurde vom Acetylen-Gasstrom langsam zur Substrat-Oberfläche zurückbewegt, wo er zersetzt wurde und das Wachstums der Kohlenstoff-Nanotubes startete. Der Beginn dieses Nanotube-Wachstums war erkennbar an der Bildung einer homogenen schwarzen Schicht auf der Substrat-Oberfläche. Die erörterten Prozeßbedingungen (Spülung mit Acetylen und Heizen des Substrates auf 650°C) wurden 40 Minuten lang aufrecht erhalten, danach wurde das mit der Nanotube-Schicht versehene Substrat mittels eines Stickstoff-Gasstromes auf Raumtemperatur abgekühlt.

Mit Hilfe der Raster-Elektronenmikroskopie (scanning electron microscopy (SEM) wurde die Morphologie der mit obigem Verfahren erzeugten Kohlenstoff-Nanotubes untersucht. Es wurden dabei isolierte, gerade Nanotube-Bündel im Bereich von Mikrometern sowie gekrümmte einzelne Nanotubes mit einigen hundert Mikrometern Länge entdeckt. Sowohl die einzelnen Nanotubes als auch die Nanotube-Bündel hatten Eisenpartikel auf ihren Spitzen. Der mittlere Durchmesser der einzelnen Nanotubes betrug in etwa 130nm, was beachtlich groß im Vergleich zu in der Literatur berichteten Durchmessern ist und mit der Größc der auf das Glassubstrat aufgebrachten Eisenpartikeln unter den erörterten Bedingungen zu erklären ist.

## Patentansprüche

1. Verfahren zur Herstellung einer Nanotube-Schicht auf einem Substrat (2) durch einen katalytischen CVD-Prozeß, bei welchem das Substrat (2) in eine Reaktionskammer (1) eingebracht wird, diese Reaktionskammer (1) mit einem kohlenstoffhältigen Gas gespült wird und das Substrat (2) auf eine Temperatur aufgeheizt wird, bei welcher Kohlenstoff aus der Gasphase am Substrat (2) abgeschieden wird und dort Nanotubes bildet, **dadurch gekennzeichnet, daß** das Substrat (2) induktiv aufgeheizt wird.

2. Verfahren nach Anspruch 1, **dadurch gekennzeichnet, daß** das Substrat (2) auf eine innerhalb der Reaktionskammer (1) angeordnete Substrat-Aufnahme (6) gelegt wird, welche durch eine Platte aus elektrisch leitendem Material, wie z.B. Metall oder Graphit, gebildet ist, und das Aufheizen des Substrates (2) durch induktives Beheizen dieser Metallplatte, gegebenenfalls zusätzlich durch induktives Beheizen von metallischen Abschnitten des Substrates (2) erfolgt.

3. Verfahren nach Anspruch 1 oder 2, **dadurch gekennzeichnet, daß** ein Substrat (2), dessen mit der Nanotube-Schicht zu versehende Oberfläche eine Metallbeschichtung aufweist, verwendet wird.

4. Verfahren nach Anspruch 1, **dadurch gekennzeichnet, daß** ein zur Gänze aus einem Metall oder einer Metallegierung bestehendes Substrat (2) verwendet wird.

5. Verfahren nach Anspruch 2, **dadurch gekennzeichnet, daß** ein aus einem nichtmetallischen Material, wie z.B. Glas, Keramik, Silizium, Cermet, Kohlenstoff od. dgl. bestehendes Substrat (2) verwendet wird und daß vor dem Spülen der Reaktionskammer (1) mit einem kohlenstoffhältigen Gas ein metallhältiger Katalysator auf die mit der Nanotube-Schicht zu versehende Oberfläche des Substrates (2) aufgebracht wird.

6. Verfahren nach Anspruch 5, **dadurch gekennzeichnet, daß** als Katalysator ein Übergangsorganometallkomplex, wie z.B. Ferrocen, verwendet wird.

7. Verfahren nach Anspruch 6, **dadurch gekennzeichnet, daß** Ferrocen in einer Aceton-Lösung aufgelöst wird und diese Aceton-Lösung auf die mit der Nanotube-Schicht zu versehende Oberfläche des Substrates (2) aufgebracht wird.

8. Verfahren nach einem der vorstehenden Ansprüche, **dadurch gekennzeichnet, daß** als kohlenstoffhältiges Gas Acetylen verwendet wird.

## Claims

1. A method for producing a nanotube layer on a substrate (2) by a catalytic CVD process in which the substrate (2) is introduced into a reaction chamber (1), with said reaction chamber (1) being scavenged with a carbon-containing gas and the substrate (2) being heated to a temperature at which the carbon is separated from the gas phase on the substrate (2) and forms nanotubes there, **characterized in that** the substrate (2) is heated inductively.

2. A method as claimed in claim 1, **characterized in that** the substrate (2) is placed on a substrate receiver (6) which is disposed within the reaction chamber (1) and is formed by a plate made of an electrically conductive material such as metal or graphite, and the heating of the substrate (2) occurs by inductive heating of said metal plate, optionally in addition by inductive heating of metallic sections of the substrate (2).

3. A method as claimed in claim 1 or 2, **characterized in that** a substrate (2) is used whose surface to be provided with the nanotube layer comprises a metal coating.

4. A method as claimed in claim 1, **characterized in that** a substrate (2) is used which consists entirely of a metal or a metal alloy.

5. A method as claimed in claim 2, **characterized in that** a substrate is used which consists of a non-metallic material such as glass, ceramics, silicon, cermet, carbon or the like and that prior to scavenging the reaction chamber (1) with a carbon-containing gas a metal-containing catalyst is applied onto the surface of the substrate (2) to be provided with the nanotube layer.

6. A method as claimed in claim 5, **characterized in that** a transition organo-metallic complex such as ferrocen is used as a catalyst.

7. A method as claimed in claim 6, **characterized in that** ferrocen is dissolved in an acetone solution and said acetone solution is applied onto the surface of the substrate (2) to be provided with the nanotube layer.

8. A method as claimed in one of the preceding claims, **characterized in that** acetylene is used as the carbon-containing gas.

## Revendications

1. Procédé de fabrication d'une couche de nanotubes sur un substrat (2) par un procédé de dépôt chimique en phase vapeur catalytique, dans lequel le substrat (2) est introduit dans une chambre de réaction (1), cette chambre de réaction (1) est parcourue par un gaz contenant du carbone et le substrat (2) est chauffé à une température à laquelle du carbone contenu dans la phase gazeuse se dépose sur le substrat (2) et y forme des nanotubes, **caractérisé en ce que** le substrat (2) est chauffé par induction.

2. Procédé selon la revendication 1, **caractérisé en ce que** le substrat (2) est déposé sur un support de substrat (6) disposé dans la chambre de réaction (1), qui est formé d'une plaque de matériau conducteur électrique, par exemple de métal ou de graphite, et le chauffage du substrat (2) est réalisé par chauffage par induction de cette plaque métallique et, éventuellement, par chauffage par induction de parties métalliques du substrat (2).

3. Procédé selon la revendication 1 ou 2, **caractérisé en ce que** l'on utilise un substrat (2) dont la surface devant être pourvue de nanotubes présente un revêtement métallique.

4. Procédé selon la revendication 1, **caractérisé en ce que** l'on utilise un substrat (2) entièrement composé d'un métal ou d'un alliage métallique.

5. Procédé selon la revendication 2, **caractérisé en ce que** l'on utilise un substrat (2) fait d'un matériau non métallique, par exemple de verre, de céramique, de silicium, de cermet, de carbone ou similaire, et **en ce qu'**avant que la chambre de réaction (1) soit parcourue par un gaz contenant du carbone, un catalyseur contenant du métal est appliqué sur la surface du substrat (2) qui doit être pourvue de nanotubes.

6. Procédé selon la revendication 5, **caractérisé en ce que** le catalyseur utilisé est un complexe organométallique de transition, par exemple du ferrocène.

7. Procédé selon la revendication 7, **caractérisé en ce que** le ferrocène est dissous dans une solution d'acétone et cette solution d'acétone est appliquée sur la surface du substrat (2) qui doit être pourvue de nanotubes.

8. Procédé selon l'une quelconque des revendications précédentes, **caractérisé en ce que** le gaz contenant du carbone utilisé est de l'acétylène.
